Europäisches Patentamt

(19) European Patent Office    (11) Publication number: **0 129 982**

Office européen des brevets    **B1**

(12) **EUROPEAN PATENT SPECIFICATION**

(45) Date of publication of patent specification: **10.08.88**    (51) Int. Cl.⁴: **H 05 K 7/18, H 01 R 23/68**

(21) Application number: **84303463.8**

(22) Date of filing: **22.05.84**

(54) Backpanel assemblies.

(30) Priority: **23.06.83 CA 431114**

(43) Date of publication of application:
**02.01.85 Bulletin 85/01**

(45) Publication of the grant of the patent:
**10.08.88 Bulletin 88/32**

(84) Designated Contracting States:
**AT CH DE FR GB LI NL SE**

(56) References cited:
**US-A-3 368 117**
**US-A-3 564 343**

(73) Proprietor: **NORTHERN TELECOM LIMITED**
**1600 Dorchester Boulevard West**
**Montreal Quebec H3H 1R1 (CA)**

(72) Inventor: **Bunner, Charles Brian David**
**13 Robertless Drive Box 201**
**Carp Ontario, KOA 1LO (CA)**
Inventor: **Brombal, David Scott**
**225 Equestrian Drive**
**Kanada Ontario, K2M 1A5 (CA)**

(74) Representative: **Crawford, Andrew Birkby et al**
**A.A. THORNTON & CO. Northumberland House**
**303-306 High Holborn**
**London WC1V 7LE (GB)**

## Description

This invention relates to backpanel assemblies.

It is known, e.g. from US-A-3368117, to provide electronic equipment, such as telecommunications equipment, with a backpanel having a plurality of elongate printed circuit board (PCB) connectors aligned in parallel thereon, into which PCBs are inserted to carry out desired functions. The backpanel, which for example is itself a multilayer printed circuit board, provides desired interconnections between the PCBs, and enables the supply of signals and power thereto, via the PCB connectors.

In such equipment, if all of the PCBs are commonly supplied with power from a single power supply, then a failure of this power supply will result in a failure of the entire equipment. Accordingly, it is desirable to enable different parts of the equipment, for example each individual PCB, to be supplied with power from different power supplies, so that a failure of one of the power supplies affects only a single PCB and does not result in failure of the entire equipment. The different power supplies, for example d.c. converters, could be powered from a reliable power source, such as the 48 volt supply of a telephone central office in the case of telecommunications equipment.

On the other hand, it is also desirable to maintain the possibility of supplying power to all of the PCBs from a single power supply, so that the equipment can be initially provided at relatively low cost, and/or in cases where failure of the entire equipment, due to failure of the single power supply, can be tolerated.

Accordingly, an object of this invention is to provide a backpanel assembly which facilitates the supply of Power to PCBs inserted into PCB connectors of the backpanel selectively from single or multiple power supplies.

According to this invention there is provided a backpanel assembly comprising a main backpanel having a plurality of elongate printed circuit board (PCB) connectors aligned in parallel thereon, the backpanel having a part extending beyond an end of the PCB connectors, the assembly including a plurality of power supply studs and a plurality of power supply pins, in respect of each of the PCB connectors, on said extending part of the backpanel, and printed circuit wiring interconnecting each power supply stud with at least one power supply pin and with the associated PCB connector, whereby power can be supplied to printed circuit boards, inserted into the PCB connectors, selectively via the associated power supply studs or via the associated power supply pins.

Thus either the power supply studs alone, or the power supply pins alone, or the studs and pins in combination, can be used to supply power to printed circuit boards when these are inserted into the PCB connectors.

In order to facilitate supplying power via the studs, preferably these are arranged in lines across the extending part of the backpanel, whereby corresponding studs associated with the different PCB connectors can be interconnected by a power supply bus for supplying power commonly to printed circuit boards inserted into the PCB connectors. The power supply studs and the power supply pins preferably extend from the extending part of the backpanel on opposite sides thereof, so that such power supply buses do not impede access to the pins, and vice versa.

In order that the power supply pins can carry a sufficiently high current, preferably the printed circuit wiring interconnects a plurality of power supply pins to a power supply stud.

A backpanel assembly in accordance with the invention can initially comprise the main backpanel and be supplied with power via the power supply buses and studs from a single power source, and can subsequently be extended by removal of the power supply buses and provision of an additional, power supply backpanel as described below with associated power supply PCBs, for individually powering the printed circuit boards inserted into the PCB connectors of the main backpanel. In view of the considerable complexity and consequent cost of the main backpanel, it is significant that a single backpanel can be provided regardless of which power supply option is desired.

The invention also extends to electronic equipment including a backpanel assembly as recited above.

The invention will be further understood from the following description with reference to the accompanying drawings, which are illustrative only and in which:

Fig. 1 is an illustration of a backpanel assembly in accordance with an embodiment of the invention, with printed circuit boards inserted into some of the PCB connectors thereon;

Fig. 2 illustrates in more detail part of the backpanel assembly of Fig. I;

Fig. 3 illustrates part of the backpanel assembly with a power bus arrangement for commonly powering the printed circuit boards from a single power source;

Fig. 4 illustrates part of the backpanel assembly with an additional power supply backpanel and power supply printed circuit boards for individually powering printed circuit boards on the main backpanel; and

Fig. 5 illustrates part of the backpanel assembly with the additional power supply backpanel and power supply printed circuit boards for individually powering groups of printed circuit boards on the main backpanel.

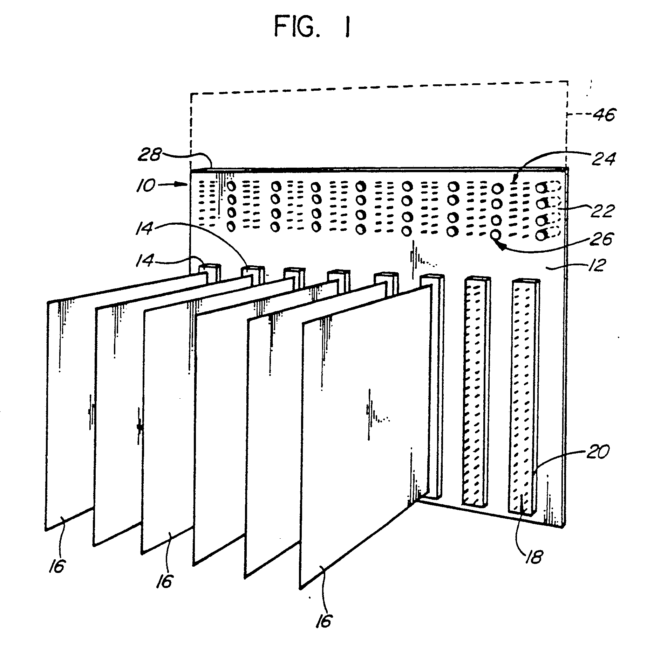

Referring to Fig. 1, there is illustrated a backpanel assembly 10 comprising a main backpanel 12 having a plurality of elongate printed circuit board (PCB) connectors 14 aligned in parallel thereon. For example 8 PCB connectors are shown, into 6 of which respective printed circuit cards or boards 16 are inserted. Although the connectors 14 can be of any known form, conveniently each connector 14 consists of two rows of pins 18 surrounded by a shroud 20 which serves to protect the pins and to guide a connector on a printed circuit board 16 into engagement and electrical contact with the pins when the PCB 16 is inserted into the connector 14. Arrangements of such pins and shrouds are known and are not further described here.

As illustrated in Fig. 1, the backpanel 12 extends upwardly beyond the upper ends of the connectors 14, its extended part 22 having thereon a set of power supply pins 24, and a set of power supply studs 26, in respect of each of the connectors 14. Like the rows of pins 18, each set of power supply pins 24 consists of two 4 rows of pins which extend adjacent to an upper edge 28 of the backpanel 12. The power supply pins 24 are conveniently aligned with the pins 18 of the respective connectors 14.

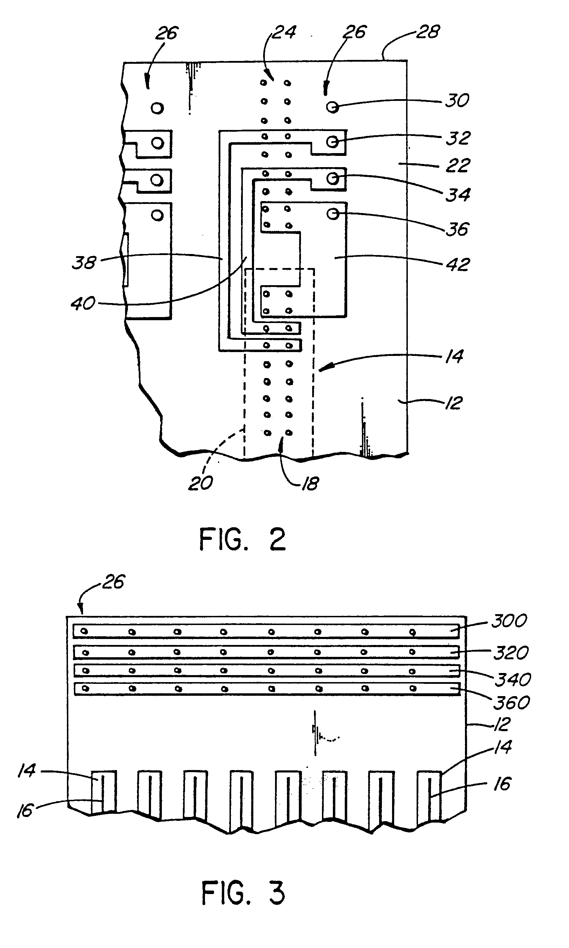

Fig. 2 illustrates in greater detail an arrangement of the pins 24 and studs 26 in relation to one of the connectors 14. The shroud 20 of the connector in Fig. 2 is represented by a broken line in order to distinguish it clearly from printed circuit wiring described below.

In Fig. 2 it is assumed that the backpanel 12 comprises a 4-layer printed circuit board having two signal circuit planes, one on each face of the board, and a power supply circuit plane and a ground plane sandwiched therebetween. It is also assumed that the power supply circuit plane has printed circuit wiring for three power supply lines, for example for voltages of +5V, +12V, and −12V relative to ground. Accordingly, in Fig. 2 each set of power supply studs 26 consists of four studs 30, 32, 34, and 36 which are respectively connected to the ground plane (not shown, for the sake of clarity), a +12V power supply printed circuit track 38 a −12V, power supply printed circuit track 40, and a +5V power supply printed circuit track 42, which is wider than the tracks 38 and 40 to enable it to carry a greater current.

As illustrated in Fig. 2, the tracks 38, 40, and 42 provide electrical connections between the power supply studs 32, 34, and 36, respective pins of the associated connector 14, and respective power supply pins 24. For example Fig. 2 illustrates each of the tracks 38 and 40 connecting to two of the pins 24 and two of the pins 18, and illustrates the track 42 connecting to four of the pins 24 and four of the pins 18. These tracks are individually provided in respect of the different connectors 14, so that printed circuit boards inserted into the respective connectors 14 are supplied with power separately from their respective sets of power supply pins 18 or 24.

In a similar manner, each stud 30 is connected via the ground plane to another one or more of the pins 18 and to other pins 24 of the respective connector 14. The ground plane may extend commonly between the various connectors 14 and the respective power supply studs and pins. For example, as shown in Fig. 2 the uppermost six power supply pins 24, i.e. those nearest to the upper edge 28 of the backpanel 12, may be connected to the ground plane. Other pins 24, which are not connected as illustrated in Fig. 2, may also be connected to the ground plane 24 to provide additional ground connections, or may be connected to one of the signal planes to provide signal path connections, or may be omitted.

In Figs. 1 and 2 it is assumed that the pins 24 extend from the backpanel 12 towards the viewer, whereas the studs 26 extend from the opposite face of the backpanel 12 away from the viewer, so that only the back ends of the studs are shown in Figs. 1 and 2. Fig. 3 illustrates part of the reverse side of the backpanel 12, showing that printed circuit boards 16 may also be inserted in connectors 14 additionally provided on this reverse side of the backpanel 12. The pins 18 conveniently extend completely through the backpanel 12 to form parts of the connectors 14 on both sides of the backpanel in known manner.

In Fig. 3 the corresponding studs 30, 32, 34, and 36 of the different sets of power supply studs 26 are interconnected by a plurality of power supply buses 300, 320, 340, and 360 respectively which extend transversely across the backpanel 12. For example each power supply bus consists of a conductive metal bar having holes therein through which the respective studs extend, the studs being threaded and provided with nuts (not shown) to clamp the bar to the studs. Thus by connection of power supply voltages to the power supply buses 300, 320, 340, and 360 from a single power supply, all of the printed circuit boards 16 are commonly supplied with power.

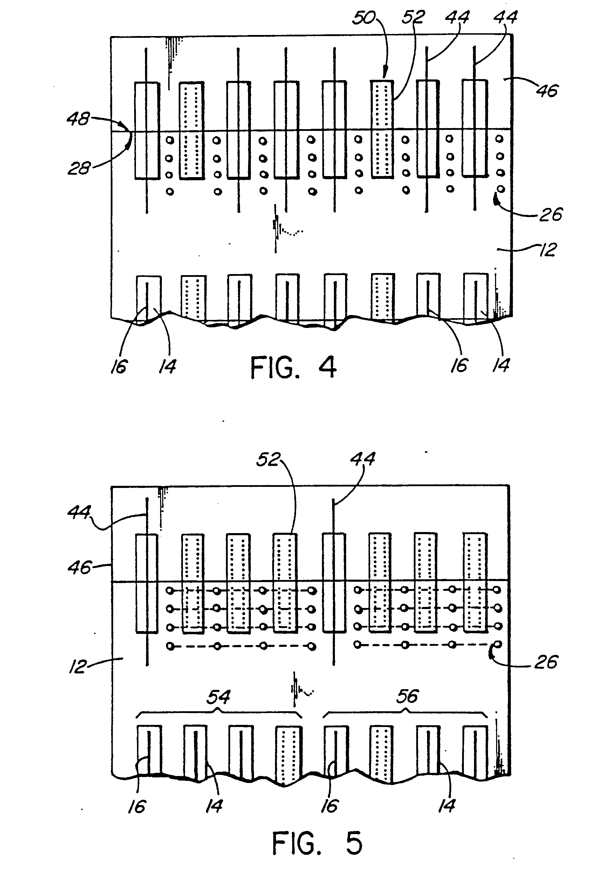

Referring now to Fig. 4, an arrangement is illustrated for supplying the printed circuit boards 16 with power from individual power supplies on power supply PCBs 44, which are themselves supplied with power from a common, reliable, power source. For example each individual power supply on a PCB 44 consists of d.c. to d.c. converters for producing the desired power supply voltages from the 48 volt power supply of a telephone central office.

To this end the arrangement of Fig. 4 includes an additional, power supply, backpanel 46 (the position of which is also illustrated in broken lines in Fig. 1) which is the same width as the backpanel 12 and which is mounted to extend upwardly therefrom in the same plane as the backpanel 12. The backpanel 46 has a lower edge 48 which abuts the upper edge 28 of the backpanel 12 so that the two backpanels are contiguous.

In the same manner that the sets of pins 24 extend upwardly on the backpanel 12 to its upper edge 28, corresponding sets of pins 50 extend on the backpanel 46 downwardly to its lower edge 48, to line up with the pins 24. In addition, shrouds 52 are mounted on the backpanel 46 to extend beyond its lower edge 48, each shroud 52 surrounding a respective set of pins 50, and also surrounding the corresponding set of pins 24 on the backpanel 12 when the two backpanels are contiguously arranged as in Fig. 4, to form therewith a respective PCB connector for a power supply PCB 44. Thus the connectors formed by the shrouds 52 are similar to the connectors 14, except that they bridge the edges 28, 48 of the backpanels and surround and align pins on both backpanels. The shrouds 52 can optionally also be secured to the backpanel 12.

For each connector 14 into which a printed circuit board 16 is inserted, a power supply PCB 44 is inserted into the corresponding connector formed by a shroud 52, pins 50, and pins 24, to supply the board 16 individually. Printed circuit wiring (not shown) on the backpanel 46 serves to supply power from the common, reliable, power source to respective ones of each set of pins 50, from whence power is delivered to the individual boards 16 via the d.c. to d.c. converters on the respective power supply PCB 44, the respective set of pins 24, and the respective printed circuit wiring of the backpanel 12 described above with reference to Fig. 2.

Instead of supplying all of the PCBs 16 commonly as in Fig. 3 or individually as in Fig. 4, groups of PCBs 16 may be supplied with power individually, with the PCBs in each group supplied commonly. For example, Fig. 5 illustrates an arrangement for supplying power individually via the backpanel 46 and two power supply PCBs 44, to two groups 54, 56 of connectors 14, and thence to PCBs 16 inserted into these connectors, the connectors 14 of each group being powered commonly by respective power supply buses interconnecting the power supply studs 26 associated with these connectors. Thus in Fig. 5 there are two sets of power supply buses, shown by broken lines because they are on the reverse side of the backpanel 12, which interconnect the lefthand four and the right hand four sets of power supply studs 26 respectively. The power supply buses and the power supply PCBs 44 and their connectors do not interfere physically with one another because they are on opposite sides of the backpanels.

## Claims

1. A backpanel assembly comprising a main backpanel having a plurality of elongate printed circuit board (PCB) connectors aligned in parallel thereon, the backpanel having a part extending beyond an end of the PCB connectors, characterized in that the assembly (10) includes a plurality of power supply studs (26) and a plurality of power supply pins (24), in respect of each of the PCB connectors (14), on said extending part (22) of the backpanel (12), and printed circuit wiring (38, 40, 42) interconnecting each power supply stud with at least one power supply pin and with the associated PCB connector, whereby power can be supplied to printed circuit boards (16), inserted into the PCB connectors, selectively via the associated power supply studs or via the associated power supply pins.

2. A backpanel assembly as claimed in claim 1 characterized in that the power supply studs (26) are arranged in lines across the extending part (22) of the backpanel (12), whereby corresponding studs (30, 32, 34, 36) associated with the different PCB connectors (14) can be interconnected by a power supply bus (300, 320, 340, 360) for supplying power commonly to printed circuit boards (16) inserted into the PCB connectors.

3. A backpanel assembly as claimed in claim 1 or 2 characterized in that the power supply studs (26) and the power supply pins (24) extend from the extending part (22) of the backpanel (12) on opposite sides thereof.

4. A backpanel assembly as claimed in any of claims 1 to 3 characterized in that said printed circuit wiring (e.g. 38) interconnects a plurality of power supply pins (24) to a power supply stud (e.g. 32).

5. A backpanel assembly as claimed in any of claims 1 to 4 characterized in that said power supply pins (24) are arranged adjacent to an end edge (28) of the extending part (22) of the backpanel (12).

6. A backpanel assembly as claimed in claim 5 characterized by including an additional, power supply, backpanel (46) arranged to extend in the same plane as the main backpanel (12) from said end edge (28) of the extending part (22) thereof, the additional backpanel having, in respect of each of the PCB connectors (14) on the main backpanel, a plurality of pins (50) aligned with and adjacent to the respective power supply pins (24) on the main backpanel, and a shroud (52) surrounding the pins on the additional backpanel and the respective power supply pins on the main backpanel, said pins (24, 50) on the two backpanels and said shroud forming a power supply PCB connector into which a power supply PCB (44) can be inserted for supplying power to a printed circuit board (16) inserted into the respective PCB connector on the main backpanel, the additional backpanel additionally having means interconnecting corresponding pins for the different power supply PCB connectors for supplying power thereto.

7. Electronic equipment characterized by comprising a backpanel assembly (10) as claimed in claim 2, a plurality of printed circuit boards (16) inserted into respective PCB connectors (14), and a plurality of power supply buses (300, 320, 340, 360) each interconnecting the corresponding power supply studs (30, 32, 34, 36) for said respective PCB connectors for supplying power commonly to the printed circuit boards (Fig. 3).

8. Electronic equipment characterized by comprising a backpanel assembly (10) as claimed in claim 6, a plurality of printed circuit boards (16) inserted into respective PCB connectors (14) on the main backpanel (12), and a like plurality of power supply PCBs (44) inserted into corresponding power supply PCB connectors (24, 50, 52) for supplying power individually to the first-mentioned printed circuit boards (Fig. 4).

9. Electronic equipment characterized by comprising a backpanel assembly (10) as claimed in claims 2 and 6, a plurality of printed circuit boards (16) inserted into respective PCB connectors (14) on the main backpanel (12), a smaller plurality of power supply PCBs (44) inserted into power supply PCB connectors (24, 50, 52) for supplying power individually to respective groups (54, 56) of the first-mentioned printed circuit boards, and a plurality of power supply buses (300, 320, 340, 360) each interconnecting the corresponding power supply studs (30, 32, 34, 36) for said respective groups for supplying power commonly to the printed circuit boards of each group (Fig. 5).

**Patentansprüche**

1. Rückwandtafelanordnung mit einer Hauptrückwandtafel, die eine Vielzahl von länglichen Verbindern für gedruckte Schaltplatinen (PCB) parallel zueinander ausgerichtet trägt, wobei die Rückwandtafel einen über ein Ende der Schaltplatinenverbinder hinausreichenden Teil besitzt, dadurch gekennzeichnet, daß die Anordnung (10) eine Vielzahl von Leistungsversorgungs-Stutzen (26) und eine Vielzahl von Leistungsversorgungsstiften (24) mit Bezug auf jeden Schaltplatinen-Verbinder (14) an dem herausstehenden Teil (22) der Rückwandtafel (12) besitzt, und daß Druckschaltungs-Verdrahtung (38, 40, 42) jeden Leistungsversorgungs-Stutzen mit mindestens einem Leistungsversorgungsstift und mit dem zugeordneten Schaltplatinen-Verbinder verbindet, wodurch Leistung den in die Schaltplatinen-Verbinder eingesetzten gedruckten Schaltplatinen (16) wahlweise über die zugeordneten Leistungsversorgungs-Stutzen oder über die zugeordneten Leistungsversorgungsstifte zugeführt werden kann.

2. Rückwandtafelanordnung nach Anspruch 1, dadurch gekennzeichnet, daß die Leistungsversorgungs-Stutzen (26) linear ausgerichtet über den herausstehenden Teil (22) der Rückwandtafel (12) angeordnet sind, wodurch entsprechende, den unterschiedlichen Schaltplatinen-Verbindern (14) zugeordnete Stutzen (30, 32, 34, 36) durch eine Leistungsversorgungs-Sammelleitung (300, 320, 340, 360) verbunden werden können, um gemeinsam Leistung den in die Schaltplatinen-Verbinder eingesetzten Schaltplatinen (16) zuzuführen.

3. Rückwandtafelanordnung nach Anspruch 1 oder 2, dadurch gekennzeichnet, daß die Leistungsversorgungs-Stutzen (26) und die Leistungsversorgungsstifte (24) von dem herausstehenden Teil (22) der Rückwandtafel (12) nach entgegengesetzten Seiten abstehen.

4. Rückwandtafelanordnung nach einem der Ansprüche 1 bis 3, dadurch gekennzeichnet, daß die gedruckte Schaltungsverdrahtung (z.B. 38) eine Vielzall von Leistungsversorgungsstiften (24) mit einem Leistungsversorgungsstutzen (z.B. 32) verbindet.

5. Rückwandtafelanordnung nach einem der Ansprüche 1 bis 4, dadurch gekennzeichnet, daß die Leistungsversorgungsstifte (24) benachbart einer Endkante (28) des herausstehenden Teils (22) der Rückwandtafel (12) angeordnet sind.

6. Rückwandtafelanordnung nach Anspruch 5, dadurch gekennzeichnet, daß sie eine zusätzliche Leistungsversorgungs-Rückwandtafel (46) enthält, die zur Erstreckung in der gleichen Ebene wie die Hauptrückwandtafel (12) von der Endkante (28) von deren herausstehendem Teil (22) angeordnet ist, daß die zusätzliche Rückwandtafel bezüglich jedem Schaltplatinen-Verbinder (14) an der Hauptrückwandtafel eine Vielzahl von mit den jeweiligen Leistungsversorgungsstiften (24) an der Hauptrückwandtafel ausgerichteten Stiften (50) benachbart zu diesen besitzt, und eine die Stifte an der zusätzlichen Rückwandtafel und die jeweiligen Leistungsversorgungsstifte an der Hauptrückwandtafel umgebende Schutzhülle (52), wobei die Stifte (24, 50) an den beiden Rückwandtafeln und die Schutzhülle einen Leistungsversorgungs-Schaltplatinenverbinder bilden, in welchen eine Leistungsversorgungs-Schaltplatine (44) eingesetzt werden kann zum Zuführen von Leistung zu einer in den jeweiligen Schaltplatinenverbinder an der Hauptrückwandtafel eingesetzten gedruckten Schaltplatine (16) und daß die zusätzliche Rückwandtafel zusätzlich Mittel besitzt, die entsprechende Stifte für die unterschiedlichen Leistungsversorgungs-Schaltplatinenverbinder zur Zuführung von Leistung zu diesen miteinander verbindet.

7. Elektronisches Gerät, dadurch gekennzeichnet, daß es eine Rückwandtafelanordnung (10) nach Anspruch 2, eine Vielzahl von in jeweilige Schaltplatinen-Verbinder (14) eingesetzte gedruckte Schaltplatinen (16) und eine Vielzahl von Leistungsversorgungs-Sammelleitungen (300, 320, 340, 360) umfaßt, die jeweils die entsprechenden Leistungsversorgungs-Stutzen (30, 32, 34, 36) für die jeweiligen Schaltplatinen-Verbinder zur gemeinsamen Zuführung von Leistung zu den gedruckten Schaltplatinen miteinander verbindet (Fig. 3).

8. Elektronisches Gerät, dadurch gekennzeichnet, daß es eine Rückwandtafelanordnung (10) nach Anspruch 6, eine Vielzahl von in jeweilige Schaltplatinen-Verbinder (14) an der Hauptrückwandtafel (12) eingesetzte Schaltplatinen (16) und eine gleiche Vielzahl von in entsprechende Leistungsversorgungs-Schaltplatinenverbinder (24, 50, 52) eingesetzten gedruckten Leistungsversorgungs-Schaltplatinen (44) umfaßt zum individuellen Zuführen von Leistung zu den ersterwähnten gedruckten Schaltplatinen (Fig. 4).

9. Elektronisches Gerät, dadurch gekennzeichnet, daß es eine Rückwandtafelanordnung (10) nach Ansprüchen 2 und 6, eine Vielzahl von in jeweilige gedruckte Schaltplatinen-Verbinder (14) an der Hauptrückwandtafel (12) eingesetzten gedruckten Schaltplatinen (16), eine kleinere Vielzahl von in Leistungsversorgungs-Schaltplatinenverbinder (24, 50, 52) eingesetzten gedruckten Leistungszuführungs-Schaltplatinen (44) zum individuellen Zuführen von Leistung zu jeweiligen Gruppen (54, 56) der ersterwähnten gedruckten Schaltplatinen und eine Vielzahl von Leistungsversorgungs-Sammelleitungen (300, 320, 340, 360) umfaßt, die jeweils die entsprechenden Leistungsversorgungs-Stutzen (30, 32, 34, 36) für die jeweiligen Gruppen miteinander verbinden zur gemeinsamen Zuführung von Leistung zu den gedruckten Schaltplatinen jeder Gruppe (Fig. 5).

**Revendications**

1. Assemblage sur panneau arrière comprenant un panneau arrière principal ayant une multitude de connecteurs allongés de plaquettes à circuits imprimés (PCI) alignés en parallèle sur celui-ci, le panneau arrière comportant une partie s'étendant au-delà d'une extrémité des connecteurs PCI, caractérisé en ce que l'assemblage (10) comporte une multitude de plots d'alimentation (26), et une multitude de broches d'alimentation (24) pour chacun des connecteurs PCI (14), sur la partie étendue (22) du panneau arrière (12), et un câblage sur circuit imprimé (38, 40, 42) interconnectant chaque plot d'alimentation à au moins une broche d'alimentation et au connecteur PCI associé, d'ou il résulte que l'énergie peut être fournie aux plaquettes à circuits imprimés (16), insérées dans les connecteurs PCI, sélectivement via les plots associés d'alimentation ou via les broches associées d'alimentation.

2. Assemblage sur panneau arrière selon la revendication 1, caractérisé en ce que les plots d'alimentation (26) sont disposés en ligne sur la partie étendue (22) du panneau arrière (12), d'ou il résulte que des plots correspondants (30, 32, 34, 36) associés aux connecteurs PCI différents (14) peuvent être interconnectés par un bus d'alimentation (300, 320, 340, 360) pour fournir de l'énergie en commun aux plaquettes à circuits imprimés (16) insérées dans les connecteurs PCI.

3. Assemblage sur panneau arrière selon la revendication 1 ou 2, caractérisé en ce que les plots d'alimentation (26) et les broches d'alimentation (24) s'étendent à partir de la partie étendue (22) du panneau arrière (12) sur ses côtés opposés.

4. Assemblage sur panneau arrière selon l'une quelconque des revendications 1 à 3, caractérisé en ce que le câblage sur circuit imprimé (par exemple 38) interconnecte une multitude de broches d'alimentation (24) à un plot d'alimentation (par exemple 32).

5. Assemblage sur panneau arrière selon l'une quelconque des revendications 1 à 4, caractérisé en ce que les broches d'alimentation (24) sont disposées près du bord d'extrémité (28) de la partie étendue (22) du panneau arrière (12).

6. Assemblage sur panneau arrière selon la revendication 5, caractérisé en ce qu'il comporte un panneau arrière (46) d'alimentation, supplémentaire, disposé de manière à s'étendre dans le même plan que le panneau arrière principal (12) à partir du bord d'extrémité (28) de sa partie étendue (22), le panneau arrière supplémentaire ayant, pour chacun des connecteurs PCI (14) du panneau arrière principal, une multitude de broches (50) en alignement, en étant adjacentes, avec les broches respectives d'alimentation (24) du panneau arrière principal, et une tôle de protection (52) entourant les broches du panneau arrière supplémentaire et les broches respectives d'alimentation du panneau arrière principal, les broches (24, 50) des deux panneaux arrière et la tôle de protection formant un connecteur PCI d'alimentation dans lequel une PCI d'alimentation (44) peut être insérée pour fournir de l'énergie à une plaquette à circuits imprimés 16 insérée dans le connecteur PCI respectif du panneau arrière principal, le panneau arrière supplémentaire ayant en outre un moyen interconnectant des broches correspondantes pour les différents connecteurs PCI d'alimentation afin de leur fournir de l'énergie.

7. Equipement électronique, caractérisé en ce qu'il comprend un assemblage sur panneau arrière (10) tel qu'il est revendiqué dans la revendication 2, une multitude de plaquettes à circuits imprimés (16) insérées dans des connecteurs PCI respectifs (14), et une multitude de bus d'alimentation (300, 320, 340, 360) interconnectant chacun les plots correspondants d'alimentation (30, 32, 34, 36) pour les connecteurs PCI respectifs afin de fournir de l'énergie en commun aux plaquettes à circuits imprimés (figure 3).

8. Equipement électronique, caractérisé en ce qu'il comprend un assemblage sur panneau arrière (10) selon la revendication 6, une multitude de plaquettes à circuits imprimés (16) insérées dans des connecteurs PCI respectifs (14) du panneau arrière principal (12), et une multitude identique de PCI d'alimentation (44) insérées dans des connecteurs PCI correspondants d'alimentation (24, 50, 52) pour fournir individuellement de l'énergie aux plaquettes à circuits imprimés citées en premier (figure 4).

9. Equipement électronique, caractérisé en ce qu'il comprend un assemblage sur panneau arrière (10) tel qu'il est revendiqué en revendications 2 et 6, une multitude de plaquettes à circuits imprimés (16) insérées dans des connecteurs PCI respectifs (14) du panneau arrière principal (12), une multitude plus petite de PCI d'alimentation (44) insérées dans des connecteurs PCI d'alimentation (24, 50, 52) pour fournir individuellement de l'énergie à des groupes respectifs (54, 56) des plaquettes à circuits imprimés citées en premier, une multitude de bus d'alimentation (300, 320, 340, 360) interconnectant chacun des plots d'alimentation correspondants (30, 32, 34, 36) pour lesdits groupes respectifs afin de fournir en commun de l'énergie aux plaquettes à circuits imprimés de chaque groupe (figure 5).

# FIG. 1

FIG. 2

FIG. 3

2

FIG. 4

FIG. 5